# EUROPEAN PATENT APPLICATION

(11) **EP 4 730 942 A1**
(43) Date of publication of application: **22.04.2026**
(21) Application number: 24918060.5
(22) Date of filing: 30.08.2024
(51) Int. Cl.: H05K 9/00

(54) **SHIELDING STRUCTURE AND ELECTRONIC APPARATUS**

(30) Priority: 16.01.2024 CN 202410066099
(71) Applicant: Huawei Technologies Co., Ltd., Shenzhen, Guangdong 518129 (CN)
(72) Inventor: DI, Wei, Shenzhen, Guangdong 518129 (CN); ZHOU, Jianjun, Shenzhen, Guangdong 518129 (CN); YU, Zhigang, Shenzhen, Guangdong 518129 (CN)
(74) Representative: Goddar, Heinz J.
(86) International application number: PCT/CN2024/116029
(87) International publication number: WO 2025/152451

(57) **Abstract**

Embodiments of this application relate to the field of electronic device technologies, and provide a shield structure and an electronic device. The electronic device includes a circuit board, a shield frame, a first shield layer, and at least one second shield layer. A plurality of electronic components are disposed on a surface of the circuit board. The shield frame is connected to the surface of the circuit board. The first shield layer covers and is connected to one side that is of the shield frame and that is away from the circuit board. The circuit board, the first shield layer, and the shield frame enclose a first shield cavity. The plurality of electronic components are disposed in the first shield cavity. The at least one second shield layer and the first shield layer are stacked. The at least one second shield layer is provided in the first shield cavity and is provided on one side that is of at least one electronic component and that is away from the circuit board. The second shield layer is coupled to the circuit board. Embodiments of this application can improve a shielding capability against electromagnetic interference and the like without increasing planar design space of the circuit board.

## Description

This application claims priority to Chinese Patent Application No. 202410066099.9, filed with the China National Intellectual Property Administration on January 16, 2024 and entitled "SHIELD STRUCTURE AND ELECTRONIC DEVICE", which is incorporated herein by reference in its entirety.

### TECHNICAL FIELD

This application relates to the field of electronic device technologies, and in particular, to a shield structure and an electronic device.

### BACKGROUND

With rapid development of electronic technologies, electronic devices have more functions, and integration of electronic components in an electronic device is increasingly high.

To ensure smooth transmission of data in the electronic components, electromagnetic interference in an environment in which the electronic components are located needs to be reduced, for example, mutual interference between the electronic components needs to be reduced.

As integration of the electronic components gradually increases, a problem of interference between the electronic components in the electronic device needs to be urgently resolved.

### SUMMARY

Embodiments of this application provide a shield structure and an electronic device, to improve a shielding capability of the electronic device against electromagnetic interference without increasing planar design space.

To achieve the foregoing objectives, the following technical solutions are used in embodiments of this application.

According to a first aspect, an electronic device is provided. The electronic device includes a circuit board, a shield frame, a first shield layer, and at least one second shield layer.

A plurality of electronic components are disposed on a surface of the circuit board. The shield frame is connected to the surface of the circuit board. The first shield layer covers and is connected to one side that is of the shield frame and that is away from the circuit board, where the circuit board, the first shield layer, and the shield frame enclose a first shield cavity; and the plurality of electronic components are located in the first shield cavity. The at least one second shield layer and the first shield layer are stacked; the at least one second shield layer is provided in the first shield cavity, the second shield layer is provided on one side that is of at least one electronic component and that is away from the circuit board, and an orthographic projection of the first shield layer on the circuit board and an orthographic projection of the at least one electronic component on the circuit board at least partially overlap; and the second shield layer is coupled to the circuit board.

In the electronic device provided in this embodiment of this application, the at least one second shield layer is provided in the first shield cavity, so that at least one second shield cavity with a smaller volume can be formed in the first shield cavity. Adding the second shield cavity with the smaller volume can increase a cut-off frequency of the electronic device and improve a shielding effect of the electronic device. In addition, interference signals such as electromagnetic waves can be significantly attenuated during transmission in a plurality of cavities (including the first shield cavity and the second shield cavity), and the shielding effect of the electronic device on the interference signals such as electromagnetic waves can also be effectively improved.

In addition, the second shield layer that is grounded and has a small area has a good suppression effect on low-frequency electromagnetic interference. To be specific, based on the first shield cavity providing shielding for the plurality of electronic components as a whole, the second shield layer may additionally increase a shielding effect on low-frequency electromagnetic interference. When integration of the electronic components is increasingly high, and the electronic device generates more low-frequency interference signals, in this embodiment of this application, shielding may be performed on the low-frequency electromagnetic interference. This helps implement shielding against full-band electromagnetic waves, so that an overall shielding effect of the electronic device on electromagnetic interference can be greatly improved.

In addition, in the electronic device provided in this embodiment of this application, a technical means of disposing the at least one second shield layer to improve the shielding effect of the electronic device does not additionally increase design space occupied by the second shield layer in a direction parallel to the surface of the circuit board. This avoids encroaching design space of another structure, such as an electronic component, disposed on the circuit board and facilitates implementation of a miniaturization design of the electronic device.

In a possible implementation of the first aspect, the second shield layer includes a plurality of first sublayers that are spaced apart in a first direction. The first direction is parallel to the circuit board. The first sublayers are provided on one side that is of the at least one electronic component and that is away from the circuit board, an orthographic projection of the first sublayers on the circuit board and the orthographic projection of the at least one electronic component on the circuit board at least partially overlap, and each first sublayer is coupled to the circuit board.

The plurality of first sublayers are provided, so that the second shield cavity may be further divided into a plurality of shield cavities with smaller volumes, to further improve a cut-off frequency and optimize the shielding effect of the electronic device.

In a possible implementation of the first aspect, at least two first sublayers that are adjacently provided are electrically connected. Therefore, a resonance problem between two first sublayers that are adjacently provided is resolved, and reliability of the electronic device is improved.

In a possible implementation of the first aspect, at least a part of a side edge of the second shield layer is in contact with the shield frame. The second shield layer is provided to be in direct contact with the shield frame, so that the second shield layer can be electrically connected to the circuit board through the shield frame. That is, the second shield layer can be grounded by being in direct contact with the shield frame, and a grounding structure does not need to be separately designed, so that difficulty in manufacturing the electronic device is reduced.

In a possible implementation of the first aspect, the electronic device further includes a first connection part. One end of the first connection part is electrically connected to the second shield layer, and the other end is electrically connected to the circuit board. That is, the second shield layer may be electrically connected to the circuit board through the first connection part, to implement grounding.

In a possible implementation of the first aspect, the electronic device further includes a second connection part, where one end of the second connection part is electrically connected to the second shield layer, and the other end is electrically connected to the shield frame. That is, after passing through the second connection part and the shield frame in sequence, the second shield layer is electrically connected to the circuit board to implement grounding.

In a possible implementation of the first aspect, the second shield layer includes at least one connection point, and the connection point is a part that is of the second shield layer and that is connected to the circuit board. When the second shield layer includes a plurality of connection points, the plurality of connection points are separately provided on two sides, in the first direction, of an electronic component covered by the second shield layer, and the first direction is parallel to the circuit board. In this way, the second shield cavity formed by the second shield layer can cover an electronic component corresponding to electromagnetic interference to be shielded.

In a possible implementation of the first aspect, the first shield layer and the at least one second shield layer are spaced apart; and/or when the electronic device includes a plurality of second shield layers, at least two second shield layers that are adjacently provided are spaced apart. In this way, the first shield cavity and the second shield cavity are independent of each other, that is, the first shield cavity and the second shield cavity each implement a shielding function, to maximize utilization of respective shielding functions, so as to further improve an overall electromagnetic shielding effect of the electronic device.

In a possible implementation of the first aspect, the electronic device further includes a first insulation layer. The first insulation layer is provided between the second shield layer and the first shield layer.

That is, the first shield layer and the second shield layer are insulated from each other, so that the first shield cavity and the second shield cavity are independent of each other, that is, the first shield cavity and the second shield cavity each implement a shielding function, to maximize utilization of respective shielding functions, so as to further improve the overall electromagnetic shielding effect of the electronic device.

In a possible implementation of the first aspect, when the shield structure includes the plurality of second shield layers, the electronic device further includes a fourth insulation layer, where the fourth insulation layer is provided between at least two second shield layers that are adjacently provided. An effect of insulating two adjacent second shield layers through the fourth insulation layer is similar to an effect of the first insulation layer in the foregoing embodiment.

In a possible implementation of the first aspect, the electronic device further includes a third shield layer and a second insulation layer. The third shield layer is provided on a side of the second shield layer, and the third shield layer and the second shield layer at least partially overlap in a direction perpendicular to the circuit board; and the third shield layer is electrically connected to the circuit board. The second insulation layer is provided between the second shield layer and the third shield layer.

The third shield layer is provided, and the second shield layer is provided to implement a capacitive coupling connection to the circuit board through the third shield layer. An area of the third shield layer may be adjusted to adjust a capacitance of a capacitive structure formed by the second shield layer and the third shield layer, so that a frequency selection effect can be formed, and shielding and suppression can be performed on electromagnetic interference of a specific frequency. In this way, the electronic device can be flexibly used in different scenarios.

In a possible implementation of the first aspect, when the second shield layer includes the plurality of first sublayers, each first sublayer and the third shield layer at least partially overlap in the direction perpendicular to the circuit board; or the third shield layer includes a plurality of second sublayers that are spaced apart in the first direction, and the first sublayer and a corresponding second sublayer at least partially overlap in the direction perpendicular to the circuit board; and the first direction is parallel to the circuit board.

That is, the plurality of first sublayers may each correspond to a separate second sublayer, to form a plurality of capacitive structures that are independent of each other. This avoids mutual influence in a frequency selection process and further improves flexibility of frequency selection of the electronic device.

In a possible implementation of the first aspect, the shield frame includes a first bracket; the first bracket is disposed around the plurality of electronic components; a first side edge of the first bracket is connected to the surface of the circuit board, and a second side edge of the first bracket is electrically connected to the first shield layer; and the first side edge and the second side edge are disposed opposite to each other. At least one first opening is disposed on the first bracket, the first opening penetrates through the first bracket in the direction parallel to the circuit board, and the first opening cuts through the first side edge of the first bracket.

That is, a surface that is of the first bracket and that faces the circuit board is not completely in contact with the circuit board, and a part of the surface is recessed in a direction away from the circuit board to form the first opening, so as to expose a part of the circuit board, so that board surface design space that is of the circuit board and that is occupied by the shield frame is reduced, and more components can be disposed on the circuit board, to facilitate implementation of a miniaturization design of the circuit board and even the electronic device.

In a possible implementation of the first aspect, the shield frame further includes a second bracket, the second bracket is connected to the second side edge of the first bracket, and the first bracket is connected to the first shield layer through the second bracket.

In a possible implementation of the first aspect, a ratio of a total size of the at least one first opening on an extension path of the first bracket to a size of the first bracket on the extension path is greater than or equal to 0.7 and less than 1.

That is, the first opening in the first bracket is disposed and occupies 70% or more of an annular region enclosed by the first bracket. This greatly reduces design space that is of the circuit board and that is occupied by the shield frame.

In a possible implementation of the first aspect, an area of the second shield layer is less than or equal to one half of an area of the first shield layer.

In a possible implementation of the first aspect, electrical conductivity of the second shield layer is greater than electrical conductivity of the first shield layer.

In a possible implementation of the first aspect, the electrical conductivity of the second shield layer is greater than or equal to 5×10⁵ S/m; and/or the electrical conductivity of the first shield layer is 0.06×10⁵ S/m to 5×10⁵ S/m.

That is, a material of the first shield layer located at an outer layer may be set as a high-loss material, and a material of the second shield layer located at an inner layer may be set as a high-conductive material. The first shield layer having a high-loss characteristic can suppress generation of a resonance problem. In addition, when electromagnetic interference generated by the electronic components reaches the second shield layer, the second shield layer having a high-conductive effect may block most electromagnetic interference, and the remaining part of electromagnetic interference leaks to the first shield layer and may be lost and dissipated in a process of transmission at the high-loss first shield layer. Under a joint effect of the high-loss first shield layer and the high-conductive second shield layer, the shielding effect on electromagnetic interference in the electronic device is greatly improved.

In a possible implementation of the first aspect, a thickness of the first shield layer is less than or equal to 0.15 mm, and/or a thickness of the second shield layer is less than or equal to 0.15 mm.

In a possible implementation of the first aspect, a coefficient of thermal conductivity of the first shield layer is greater than or equal to 50 W/(m×K), and/or a coefficient of thermal conductivity of the second shield layer is greater than or equal to 50 W/(m×K). Therefore, while implementing a good electromagnetic shielding effect in the electronic device, the electronic device can further have a good heat dissipation effect, thereby achieving a balance between the two.

In a possible implementation of the first aspect, a material of the first shield layer includes at least one of a carbon nanotube, graphene, carbon black, or a two-dimensional transition metal carbide (nitride). In this way, the first shield layer has a high dielectric loss and has the good heat dissipation effect.

According to a second aspect, a shield structure is provided, including a first shield layer and at least one second shield layer. At least one second shield layer and the first shield layer are stacked and are connected, and an area of the second shield layer is less than an area of the first shield layer.

In an embodiment, the shield structure is used in an electronic device, where the electronic device includes a circuit board and a shield frame, and a plurality of electronic components are disposed on a surface of the circuit board; the shield frame is connected to the surface of the circuit board; the first shield layer is configured to cover and to be connected to one side that is of the shield frame and that is away from the circuit board, and the first shield layer may be configured to enclose a first shield cavity with the circuit board and the shield frame; and the plurality of electronic components are located in the first shield cavity.

In an embodiment, the at least one second shield layer is configured to be provided in the first shield cavity.

In an embodiment, the second shield layer is configured to be provided on one side that is of at least one electronic component and that is away from the circuit board, and an orthographic projection of the second shield layer on the circuit board and an orthographic projection of the at least one electronic component on the circuit board at least partially overlap; and the second shield layer is configured to be coupled to the circuit board. In a possible implementation of the second aspect, the second shield layer includes a plurality of first sublayers that are spaced apart in a first direction; the first direction is parallel to the first shield layer; and the first sublayers and the first shield layer are stacked and are connected.

In a possible implementation of the second aspect, at least two first sublayers that are adjacently provided are electrically connected.

In a possible implementation of the second aspect, the area of the second shield layer is less than or equal to one half of the area of the first shield layer.

In a possible implementation of the second aspect, electrical conductivity of the second shield layer is greater than electrical conductivity of the first shield layer.

In a possible implementation of the second aspect, the electrical conductivity of the second shield layer is greater than or equal to 5×10⁵ S/m; and/or the electrical conductivity of the first shield layer is 0.06×10⁵ S/m to 5×10⁵ S/m.

In a possible implementation of the second aspect, a thickness of the first shield layer is less than or equal to 0.15 mm, and/or a thickness of the second shield layer is less than or equal to 0.15 mm.

In a possible implementation of the second aspect, a coefficient of thermal conductivity of the first shield layer is greater than or equal to 50 W/(m×K), and/or a coefficient of thermal conductivity of the second shield layer is greater than or equal to 50 W/(m×K).

In a possible implementation of the second aspect, a material of the first shield layer includes at least one of a carbon nanotube, graphene, carbon black, or a two-dimensional transition metal carbide (nitride).

For technical effects brought by the shield structure provided in any one of the second aspect, refer to the technical effects brought by a design manner of the electronic device in the first aspect. Details are not described herein again.

### BRIEF DESCRIPTION OF DRAWINGS

FIG. 1 is a diagram of a structure of an electronic device according to an embodiment of this application;
FIG. 2 is a sectional view along a section line A-A' in FIG. 1;
FIG. 3 is an exploded view of a structure of an electronic device according to an embodiment of this application;
FIG. 4 is an assembly diagram of a structure of an electronic device according to an embodiment of this application;
FIG. 5 is a sectional view along a section line B-B' in FIG. 4;
FIG. 6 is a diagram of another structure of an electronic device according to an embodiment of this application;
FIG. 7 is a diagram of another structure of an electronic device according to an embodiment of this application;
FIG. 8 is a diagram of another structure of an electronic device according to an embodiment of this application;
FIG. 9 is a diagram of another structure of an electronic device according to an embodiment of this application;
FIG. 10 is a diagram of another structure of an electronic device according to an embodiment of this application;
FIG. 11 is a diagram of another structure of an electronic device according to an embodiment of this application;
FIG. 12 is another sectional view along a section line B-B' in FIG. 4;
FIG. 13 is a diagram of another structure of an electronic device according to an embodiment of this application;
FIG. 14 is a diagram of another structure of an electronic device according to an embodiment of this application;
FIG. 15 is a diagram of another structure of an electronic device according to an embodiment of this application;
FIG. 16 is a sectional view along a section line C-C' in FIG. 13;
FIG. 17 is a diagram of another structure of an electronic device according to an embodiment of this application; and
FIG. 18 is a diagram of an orthographic projection of a first bracket in a shield frame on a circuit board.

### DESCRIPTION OF EMBODIMENTS

The following clearly and completely describes technical solutions in some embodiments of this application with reference to the accompanying drawings. It is clear that the described embodiments are merely some rather than all embodiments of this application. All other embodiments obtained by a person of ordinary skill in the art based on embodiments of this application shall fall within the protection scope of this application.

In the descriptions of this application, it should be understood that orientations or position relationships indicated by terms such as "center", "above", "below", "front", "rear", "left", "right", "vertical", "horizontal", "top", "bottom", "inside", and "outside" are based on the orientations or the position relationships shown in the accompanying drawings, and are merely intended to describe this application and simplify the descriptions, but not intended to indicate or imply that an indicated apparatus or element shall have a specific direction or be constructed and operated in a specific orientation. Therefore, such terms cannot be understood as a limitation on this application.

Unless otherwise required in the context, throughout the entire specification and claims, the term "include" is interpreted as "open and inclusive", that is, "include but not limited to". In the description of this specification, terms such as "an embodiment", "some embodiments", "an example embodiment", "an example", or "some examples" are intended to indicate that a specific feature, structure, material, or characteristic related to embodiments or examples are included in at least one embodiment or example of this application. The schematic representations of the foregoing terms do not necessarily mean a same embodiment or example. In addition, the specific feature, structure, material, or characteristic may be included in any one or more embodiments or examples in any appropriate manner.

The following terms "first", "second", and the like are merely intended for description, and shall not be understood as an indication or implication of relative importance or an implicit indication of a quantity of indicated technical features. Therefore, a feature limited by "first" or "second" may explicitly or implicitly include one or more features. In the descriptions of embodiments of this application, unless otherwise specified, "a plurality of" means two or more than two.

Connection/connection may mean a mechanical connection relationship or a physical connection relationship, that is, that A and B are connected or that A is connected to B may mean that there is a fastening component (such as a screw, a bolt, or a nail) between A and B, or A and B are in contact with each other and are difficult to be separated. A and B may be fastened, may be detachably connected, may be integrated, may be directly connected, or may be indirectly connected through an intermediate medium.

Coupling may be understood as direct coupling and/or indirect coupling, and a "coupling connection" may be understood as a direct coupling connection and/or an indirect coupling connection. The direct coupling may also be referred to as an "electrical connection" and may be understood as physical contact and electrical conduction of components, for example, a form in which different components in a line structure are connected through physical lines that can transmit an electrical signal, such as a printed circuit board (printed circuit board, PCB) copper foil or a conducting wire. The "indirect coupling" may be understood as electrical conduction of two conductors in a spaced/non-contact manner. In an embodiment, the indirect coupling may also be referred to as capacitive coupling. For example, signal transmission is implemented by forming an equivalent capacitance through coupling in a gap between two conductive members.

"At least one of A, B, and C" and "at least one of A, B, or C" have the same meaning, and both include the following combinations of A, B, and C: only A, only B, only C, a combination of A and B, a combination of A and C, a combination of B and C, and a combination of A, B, and C.

"A and/or B" includes the following three combinations: only A, only B, and a combination of A and B.

As used herein, "parallel", "perpendicular to", and "equal to" include described cases and similar cases. A range of a similar case is in an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular to" includes "absolutely perpendicular to" and "approximately perpendicular to", and an acceptable deviation range of "approximately perpendicular to" may also be, for example, a deviation within 5°. "Equal to" includes "absolutely equal to" and "approximately equal to". An acceptable deviation range of "approximately equal to" may be that, for example, a difference between two equal objects is less than or equal to 5% of either of the two objects.

Example implementations are described herein with reference to sectional views and/or plane views that are used as idealized example accompanying drawings. In the accompanying drawings, for clarity, thicknesses of layers and regions are enlarged. Therefore, a change in a shape in the accompanying drawings due to, for example, manufacturing techniques and/or tolerances may be envisaged. Therefore, example implementations should not be construed as being limited to a shape of a region shown herein, but include shape deviations due to, for example, manufacturing. Therefore, the regions shown in the accompanying drawings are essentially examples, and shapes of the regions are not intended to show actual shapes of regions of a device, and are not intended to limit a scope of the example implementations.

In addition, a scenario described in embodiments of this application is intended to describe the technical solutions in embodiments of this application more clearly, but does not constitute a limitation on the technical solutions provided in embodiments of this application. A person of ordinary skill in the art may learn that as a new scenario emerges, the technical solutions provided in embodiments of this application are also applicable to a similar technical problem.

An embodiment of this application provides an electronic device. The electronic device may be different types of user equipment or terminal devices such as a mobile phone (Mobile Phone), a tablet computer (Pad), a personal digital assistant (Personal Digital Assistant, PDA), a television, an intelligent wearable product (for example, a smartwatch or a smart band), a virtual reality (Virtual Reality, VR) terminal device, an augmented reality (Augmented Reality, AR) terminal device, a small rechargeable household appliance (for example, a soy milk machine and a robotic vacuum cleaner), an unmanned aerial vehicle, a radar, an aerospace device, a vehicle-mounted device, and a vehicle. The electronic device may alternatively be a network device like a base station. A specific form of the electronic device is not specifically limited in embodiments of this application.

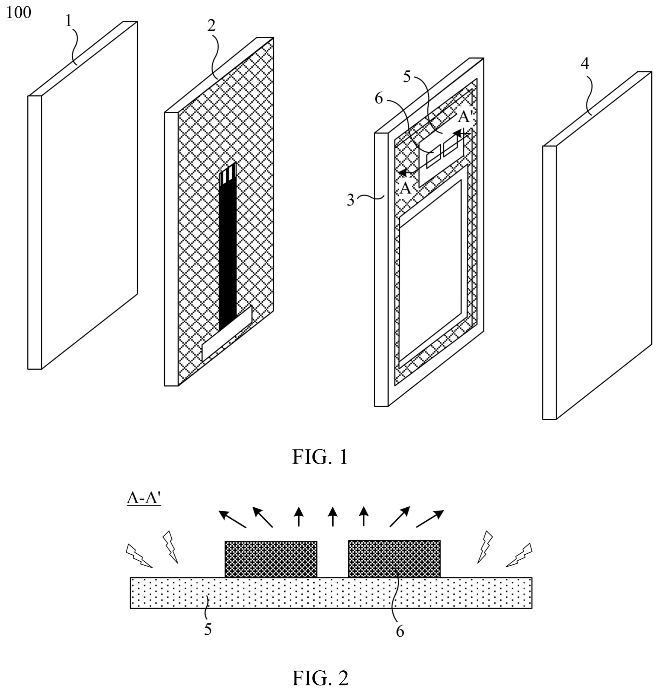

For ease of description, the following uses an example in which the electronic device is a mobile phone for description. This cannot be considered as a specific limitation on a structure form of the electronic device. FIG. 1 is a diagram of a structure of an electronic device 100 according to an embodiment of this application. FIG. 2 is a sectional view along a section line A-A' in FIG. 1.

In some embodiments, as shown in FIG. 1, the electronic device 100 may include a cover plate 1, a display 2, a middle frame 3, and a rear housing 4. The display 2 has a light-emitting side and a non-light-emitting side that are opposite to each other. The light-emitting side is one side on which a display surface of the display 2 is located (for example, a left side of the display 2 in FIG. 1), and the non-light-emitting side is one side opposite to the light-emitting side (for example, a right side of the display 2 in FIG. 1). The cover plate 1 is disposed on the light-emitting side of the display 2 and is attached to the display 2. The middle frame 3 and the rear housing 4 are disposed on the non-light-emitting side of the display 2, the rear housing 4 and the display 2 are respectively located on two sides of the middle frame 3, and the middle frame 3 and the display 2 are disposed in the rear housing 4.

For example, with reference to FIG. 1, the middle frame 3 may include a bearing plate and a side frame around the bearing plate. The electronic device 100 may further include structures, such as a battery and a camera, disposed on the bearing plate.

As shown in FIG. 1, the electronic device 100 may further include a circuit board 5.

For example, with reference to FIG. 1, the circuit board 5 may be located on the non-light-emitting side of the display 2. For example, the circuit board 5 may be located between the bearing plate and the rear housing 4.

As shown in FIG. 1 and FIG. 2, a plurality of electronic components 6 are disposed on the circuit board 5.

For example, the plurality of electronic components 6 may be disposed on a side of the circuit board 5, or the electronic components 6 may be disposed on both sides of the circuit board 5. In FIG. 2, only an example in which the electronic components 6 are disposed on a side of the circuit board 5 is used for schematic description, and a specific position of the electronic components 6 is not limited.

For example, the circuit board 5 includes, for example, a primary circuit board and a secondary circuit board. The plurality of electronic components 6 are disposed on the primary circuit board and/or the secondary circuit board.

For example, the primary circuit board in the circuit board 5 may be configured to integrate an electronic component 6 such as a control chip. The control chip includes but is not limited to a system on chip (system on chip, SOC), a charging management chip, a power management chip (power management unit, PMU), a radio frequency (radio frequency, RF) chip, a display chip, an application processor (application processor, AP), a double data rate (double data rate, DDR) synchronous dynamic random access memory, a general-purpose memory (universal flash storage, UFS), and the like. The radio frequency chip may also be referred to as a radio frequency power amplifier (radio frequency power amplifier, RF PA) chip. For example, the primary circuit board is electrically connected to the display 2, and the primary circuit board is configured to control the display 2 to display an image or a video.

The primary circuit board may be a printed circuit board (printed circuit board, PCB). Certainly, the primary circuit board may alternatively be a flexible circuit board, a rigid-flex circuit board, or the like. Optionally, the primary circuit board may be fastened between the middle frame 3 and the rear housing 4 through threaded connection, clamping, adhesive bonding, or the like.

For example, an electronic component 6 such as a serial bus (universal serial bus, USB) component may be integrated on the secondary circuit board in the circuit board 5. The USB component may be a USB type-C interface component, a USB type-A interface component, a USB type Micro-B interface component, or a USB type-B interface component. A port is provided at a position, on a side frame, corresponding to the USB component. Accessories such as a charger, a headset, and a data cable may be electrically connected to the USB component through the port, to implement transmission of a power supply, a signal, and data.

The secondary circuit board may be a printed circuit board. Certainly, the primary circuit board may alternatively be a flexible circuit board, a rigid-flex circuit board, or the like. The secondary circuit board may also be fastened between the middle frame 3 and the rear housing 4 through thread connection, clamping, adhesive bonding, soldering, or the like. The secondary circuit board and the primary circuit board are spaced apart and are electrically connected.

In an operating process of the electronic device 100, the electronic components 6 on the circuit board 5 (for example, on the primary circuit board and/or the secondary circuit board) generate a large amount of electromagnetic interference (as indicated by an arrow in FIG. 2), which affects normal implementation of a function of another structure (for example, the display 2) of the electronic device 100. In addition, a large amount of electromagnetic interference (shown by a lightning icon in FIG. 2) also exists in a surrounding environment of the electronic components 6, which easily affects the electronic components 6. Consequently, a function implementation effect of the electronic components 6 is poor (for example, a signal transmission deviation may occur), and even the electronic device 100 may be faulty.

To ensure normal operation of the electronic components 6 in the electronic device 100, the foregoing electromagnetic interference needs to be shielded by using a shield structure.

In some embodiments, the shield structure includes a shield frame and a shield cover. The shield frame is soldered to the circuit board 5, and one side that is of the shield frame and that is away from the circuit board 5 is fastened to the shield cover, to form a shield cavity having a Faraday shielding effect.

The shield structure is configured to cover the electronic components 6 of the circuit board 5. For example, all electronic components 6 on a same side of the circuit board 5 are covered in the shield cavity, so that electromagnetic interference in an external environment is shielded, and external electromagnetic interference is blocked from being transmitted to the electronic components 6 covered by the shield cavity, to avoid impact on normal operation of the electronic components 6. In addition, electromagnetic interference generated by the electronic components 6 is shielded, and the electromagnetic interference generated by the electronic components 6 covered by the shield cavity is blocked in the shield cavity, to avoid impact on function implementation of an external component.

However, as integration of the electronic components 6 gradually increases, electromagnetic interference generated by the electronic components 6 on the circuit board 5 gradually increases. With development of electronic technologies, electromagnetic interference sources (that is, noise sources) in an external environment of the electronic components 6 also gradually increase, and frequencies of electromagnetic waves from the foregoing two sources also gradually diversify. Consequently, more electromagnetic interference leaks from the shield cavity. A shielding effect of the shield structure in this embodiment cannot meet a shielding requirement gradually, and reliability of the electronic device 100 is reduced.

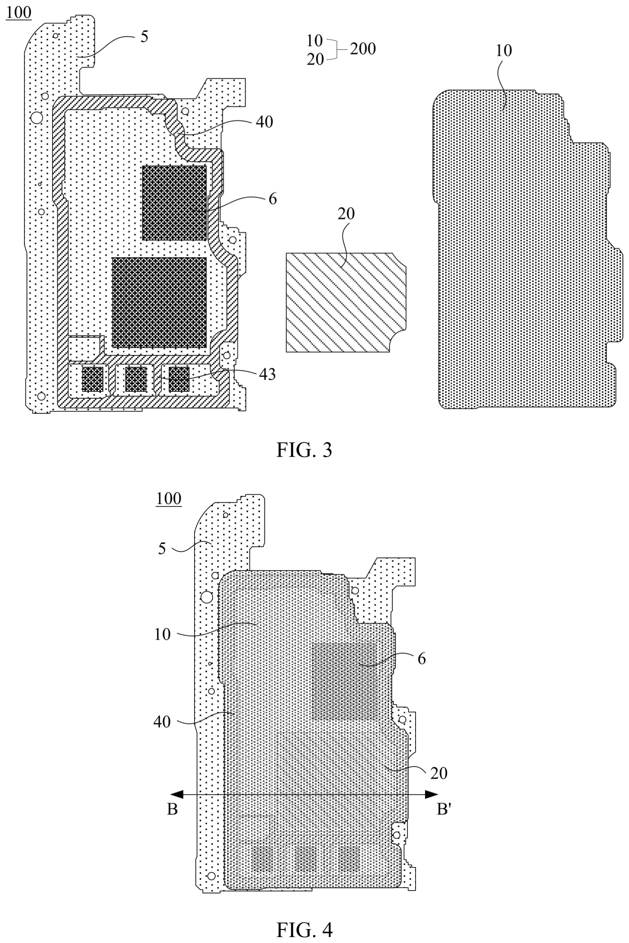

To resolve the foregoing technical problem, as shown in FIG. 3, this application provides a shield structure 200, including a first shield layer 10 and at least one second shield layer 20.

As shown in FIG. 3 or FIG. 4, the at least one second shield layer 20 and the first shield layer 10 are stacked and connected, where an area of the second shield layer 20 is less than an area of the first shield layer 10.

In an embodiment, the shield structure 200 provided in this application may be used in the electronic device 100. The electronic device 100 includes a circuit board 5 and a shield frame 40. A plurality of electronic components 6 are disposed on a surface of the circuit board 5. The shield frame 40 is connected to the surface of the circuit board 5.

The first shield layer 10 of the shield structure 200 may be configured to cover and be connected to one side that is of the shield frame 40 and that is away from the circuit board 5, and the first shield layer 10 may be configured to enclose a first shield cavity with the circuit board 5 and the shield frame 40. The plurality of electronic components 6 are located in the first shield cavity Q1.

The at least one second shield layer 20 of the shield structure 200 is configured to be provided in the first shield cavity Q1.

In an embodiment, the second shield layer 20 is configured to be provided on one side that is of at least one electronic component 6 and that is away from the circuit board 5, and an orthographic projection of the second shield layer 20 on the circuit board 5 and an orthographic projection of the at least one electronic component 6 on the circuit board 5 at least partially overlap. The second shield layer 20 is configured to be coupled to the circuit board 5.

This application further provides an electronic device 100.

FIG. 3 is an exploded view of a structure of the electronic device 100 according to an embodiment of this application. FIG. 4 is an assembly diagram of the structure of the electronic device 100 according to an embodiment of this application.

As shown in FIG. 3 and FIG. 4, the electronic device 100 includes the shield frame 40, the first shield layer 10, and the at least one second shield layer 20.

The shield frame 40, the first shield layer 10, and the at least one second shield layer 20 are configured to cover the surface of the circuit board 5 and cover the plurality of electronic components 6 on the circuit board 5.

With reference to FIG. 3 and FIG. 4, the shield frame 40 is connected to the surface of the circuit board 5.

For example, with reference to FIG. 3 and FIG. 4, the shield frame 40 is approximately in an annular shape (that is, a hollow frame structure), to surround the plurality of electronic components 6, so as to reduce a probability that electromagnetic interference generated by the electronic components 6 leaks out from a direction parallel to the circuit board 5.

For example, the shield frame 40 may be in a shape of a circular ring or a square ring, or may be in another ring-like shape based on a design of a board surface of the circuit board 5. This is not limited in this application.

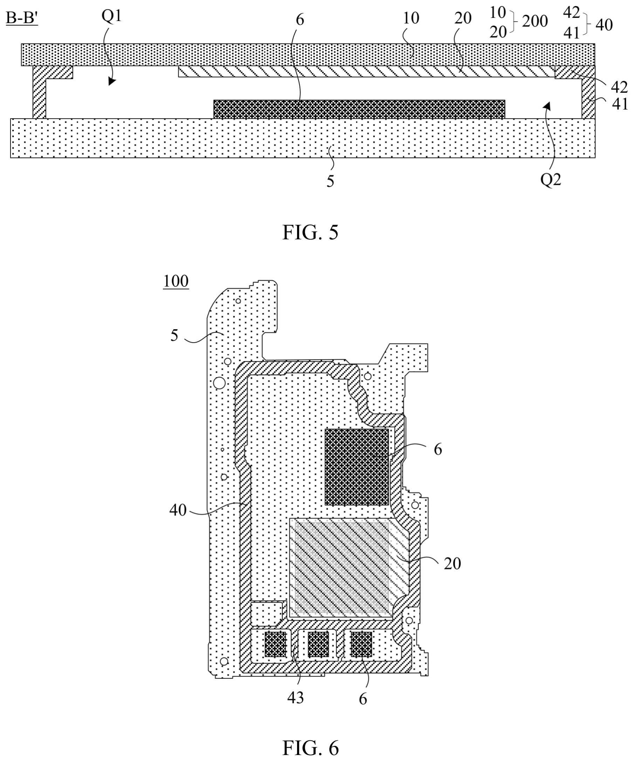

FIG. 5 is a sectional view along a section line B-B' in FIG. 4.

For example, the shield frame 40 may be soldered to the surface of the circuit board 5, or may be fastened to the circuit board 5 in another connection manner, for example, clamping, bolt connection, or bonding. This is not limited in this application.

It may be understood that the shield frame 40 is electrically connected to the circuit board 5, for example, is electrically connected to a position, of the circuit board 5, where no electronic component or signal cable is disposed, to facilitate implementation of grounding of the shield frame 40, the first shield layer 10, and the at least one second shield layer 20, so that electromagnetic interference is eliminated, and functions, such as electromagnetic shielding and electrostatic elimination, of the electronic device 100 are implemented.

For example, a material of the shield frame 40 may include a conductive material, for example, may be a metal material, for example, may include a metal material such as copper or silver, for example, may be a material such as nickel silver or stainless steel.

For example, with reference to FIG. 5, the shield frame 40 may include a first bracket 41 and a second bracket 42.

The first bracket 41 is configured to be fastened to the circuit board 5, and the second bracket 42 is configured to be fastened to the first shield layer 10.

For example, both the first bracket 41 and the second bracket 42 may be disposed in an annular manner.

For example, with reference to FIG. 5, a plane in which the first bracket 41 is located and a plane in which the second bracket 42 is located intersect, for example, are perpendicular to each other. For example, with reference to FIG. 5, the first bracket 41 may be perpendicular to the surface of the circuit board 5, to provide a specific height for the electronic device 100, so as to avoid direct contact between the first shield layer 10 and the electronic components 6. The second bracket 42 may be parallel to the surface of the circuit board 5, so that the shield frame 40 and the first shield layer 10 are connected (for example, may be electrically connected).

For example, a width of the second bracket 42 may be greater than or equal to 0.4 mm.

For example, with reference to FIG. 3 and FIG. 4, the shield frame 40 may further include a middle bracket 43. The middle bracket 43 may be disposed between two adjacent electronic components 6, to facilitate implementation of mutual shielding between the two adjacent electronic components 6.

For example, the middle bracket 43 and the second bracket 42 may be disposed on a same layer.

For example, the first bracket 41, the second bracket 42, and the middle bracket 43 may be integrally disposed.

With reference to FIG. 3, FIG. 4, and FIG. 5, the first shield layer 10 covers and is connected to one side that is of the shield frame 40 and that is away from the circuit board 5. In other words, the first shield layer 10 is buckled on an opening on a side of the shield frame 40, so that the first shield layer 10, the circuit board 5, and the shield frame 40 enclose the first shield cavity Q1 (refer to FIG. 5).

With reference to FIG. 4 and FIG. 5, the plurality of electronic components 6 are located in the first shield cavity Q1 enclosed by the shield frame 40 and the first shield layer 10, so that electromagnetic interference generated by the plurality of electronic components 6 is blocked in the first shield cavity Q1, and electromagnetic interference in an external environment is also blocked from being conducted to the plurality of electronic components 6, to implement an electromagnetic shielding effect.

In addition, the first shield cavity Q1 may further eliminate static electricity in the electronic device 100, to improve reliability of the electronic device 100.

It may be understood that, through support of the shield frame 40, there is a spacing between the first shield layer 10 and the electronic components 6, to avoid a problem such as a short circuit caused by contact between the first shield layer 10 and the electronic components 6.

For example, an insulation layer may be further provided between the first shield layer 10 and the electronic components 6. This can also avoid an electrical connection between the first shield layer 10 and the electronic components 6. For example, a thermally conductive adhesive (not shown in the figure) may be disposed between the first shield layer 10 and the electronic components 6, to implement heat dissipation when the first shield layer 10 and the electronic components 6 are insulated.

For example, with reference to FIG. 4, an appearance of the first shield layer 10 may match a shape of the shield frame 40, to implement connection between the first shield layer 10 and the shield frame 40.

For example, the first shield layer 10 and the shield frame 40 may be integrally disposed, or may be connected in an assembly manner. For example, a folded tab (not shown in the figure) may be disposed at an edge of the first shield layer 10, to facilitate insertion to the shield frame 40.

With reference to FIG. 3, FIG. 4, and FIG. 5, the at least one second shield layer 20 and the first shield layer 10 are stacked.

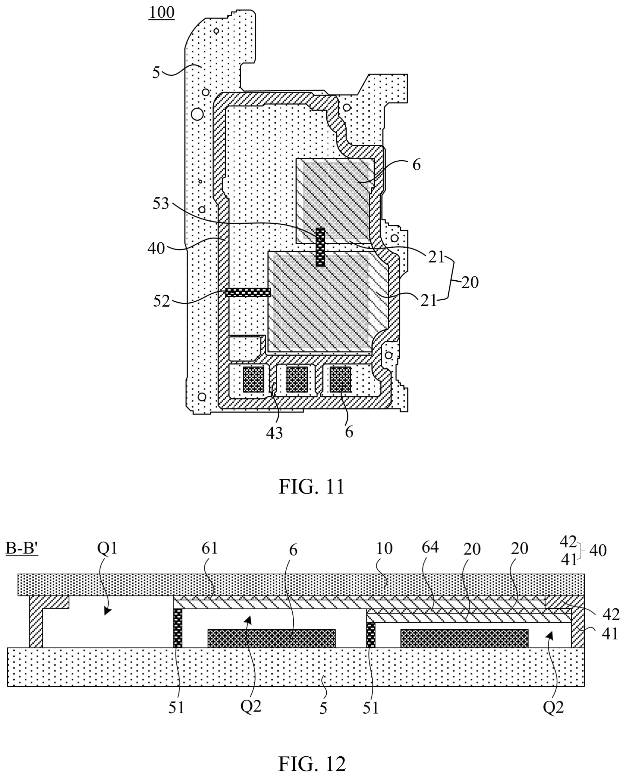

It may be understood that, in this embodiment of this application, the electronic device 100 may include one or more second shield layers 20. For example, with reference to FIG. 5, the electronic device 100 may include one second shield layer 20, and the second shield layer 20 and the first shield layer 10 are stacked. Alternatively, for example, with reference to subsequent FIG. 12, the electronic device 100 may include a plurality of second shield layers 20 (two second shield layers 20 are used as an example in FIG. 12), and the plurality of second shield layers 20 are stacked one on another and are stacked together with the first shield layer 10.

With reference to FIG. 3, FIG. 4, and FIG. 5, the at least one second shield layer 20 is provided in the first shield cavity Q1, that is, the area of the second shield layer 20 is less than the area of the first shield layer 10, and the second shield layer 20 is provided on one side that is of the first shield layer 10 and that is close to the circuit board 5.

For example, with reference to FIG. 4, the area of the second shield layer 20 is less than one half of the area of the first shield layer 10.

For example, a ratio of the area of the second shield layer 20 to the area of the first shield layer 10 may be 0.0625 to 0.5. For example, a ratio of the two areas may be 0.0625, 0.1, 0.175, or 0.5. For example, both the first shield layer 10 and the second shield layer 20 may be square, a side length of the first shield layer 10 may be 4 cm, and a side length of the second shield layer 20 may be 1 cm.

For example, the second shield layer 20 and the first shield layer 10 may be spaced apart and stacked.

For example, there may be an air gap between the second shield layer 20 and the first shield layer 10.

Alternatively, for example, the second shield layer 20 and the first shield layer 10 may be spaced apart by using an insulation material or another material.

For example, the second shield layer 20 may be connected to the first shield layer 10.

For example, a bonding adhesive may be disposed between the second shield layer 20 and the first shield layer 10 to implement a connection between the second shield layer 20 and the first shield layer 10, or the second shield layer 20 and the first shield layer 10 may be integrally provided, or the second shield layer 20 and the first shield layer 10 may be directly attached. This is not limited in this application.

With reference to FIG. 3, FIG. 4, and FIG. 5, the second shield layer 20 is further provided on one side that is of the at least one electronic component 6 and that is away from the circuit board 5, and the orthographic projection of the second shield layer 20 on the circuit board 5 and the orthographic projection of the at least one electronic component 6 on the circuit board 5 at least partially overlap.

That is, when the circuit board 5 includes the plurality of electronic components 6, the second shield layer 20 may cover one or more electronic components 6 in the plurality of electronic components 6. Alternatively, it may be understood that the second shield layer 20 is provided above a surface that is of the at least one electronic component 6 and that is away from the circuit board 5. For example, the second shield layer 20 may be suspended on the surface that is of the electronic component 6 and that is away from the circuit board 5, or may be attached, in an insulated manner, to the surface that is of the electronic component 6 and that is away from the circuit board 5.

For example, the second shield layer 20 may cover (including suspended coverage or insulated attachment coverage) an electronic component 6 with strong electromagnetic interference in the plurality of electronic components 6. For example, the second shield layer 20 may cover a surface that is of at least one of a system on chip (system on chip, SOC for short), a power management chip (Power Management Unit, PMU for short), a charging chip, and a radio frequency chip and that is away from the circuit board 5.

It may be understood that the area of the second shield layer 20 may depend on areas and a quantity of electronic components 6 to be covered by the second shield layer 20, and a shape of the second shield layer 20 also depends on positions of the electronic components 6 to be covered by the second shield layer 20.

For example, the second shield layer 20 may be provided on a surface-insulated electronic component 6 through spraying, electroplating, sputtering, or the like, or the second shield layer 20 may be adsorbed on a surface-insulated electronic component 6 through negative-pressure air extraction or may be suspended or stacked on an electronic component 6, or the second shield layer 20 may be integrally provided with the first shield layer 10 and the area of the second shield layer 20 is made less than the area of the first shield layer 10 through cutting.

For example, the at least one second shield layer 20 is insulated from the electronic components 6.

For example, the at least one second shield layer 20 and the electronic components 6 may be spaced apart. For example, the at least one second shield layer 20 may be connected to the first shield layer 10, so that the second shield layer 20 may be suspended by being fastened to the first shield layer 10, to avoid a problem such as a short circuit caused by direct contact between the second shield layer 20 and the electronic components 6.

Alternatively, for example, the at least one second shield layer 20 and the electronic components 6 may be insulated by disposing the insulation layer.

With reference to FIG. 5, the second shield layer 20 provided between the circuit board 5 and the first shield layer 10 may form at least one second shield cavity Q2 with a smaller volume in the first shield cavity Q1 (for example, two second shield cavities Q2 are formed in FIG. 12), and the second shield cavity Q2 surrounds a part of electronic components 6 in the plurality of electronic components 6, to implement electromagnetic shielding or electrostatic elimination for the part of electronic components 6.

With reference to FIG. 5, the second shield layer 20 is coupled to the circuit board 5. For example, the second shield layer 20 and the circuit board 5 are directly coupled, for example, electrically connected, or the second shield layer 20 and the circuit board 5 may be indirectly coupled, for example, in capacitive coupling connection, to implement grounding of the second shield layer 20, so as to dissipate interference electromagnetic waves or static electricity in the second shield cavity Q2.

In the electronic device 100 provided in this embodiment of this application, the at least one second shield layer 20 is provided in the first shield cavity Q1, so that the at least one second shield cavity Q2 with the smaller volume can be formed in the first shield cavity Q1. Adding the second shield cavity Q2 with the smaller volume can increase a cut-off frequency of the electronic device 100 and improve a shielding effect of the electronic device 100. In addition, interference signals such as electromagnetic waves can be significantly attenuated during transmission in a plurality of cavities (including the first shield cavity Q1 and the second shield cavity Q2), and the shielding effect of the electronic device 100 on the interference signals such as electromagnetic waves can also be effectively improved.

In addition, the second shield layer 20 that is grounded and has a small area has a good suppression effect on low-frequency electromagnetic interference. To be specific, based on the first shield cavity Q1 providing shielding for the plurality of electronic components 6 as a whole, the second shield layer 20 may additionally increase a shielding effect on low-frequency electromagnetic interference. When integration of the electronic components 6 is increasingly high, and the electronic device 100 generates more low-frequency interference signals, in this embodiment of this application, shielding may be performed on the low-frequency electromagnetic interference. This helps implement shielding against full-band electromagnetic waves, so that an overall shielding effect of the electronic device 100 on electromagnetic interference can be greatly improved.

In addition, refer to FIG. 4 and FIG. 5. In the electronic device 100 provided in this embodiment of this application, a technical means of disposing the at least one second shield layer 20 to improve the shielding effect of the electronic device 100 does not additionally increase design space occupied by the second shield layer 20 in the direction parallel to the surface of the circuit board 5. This avoids encroaching design space of another structure, such as an electronic component 6, disposed on the circuit board 5 and facilitates implementation of a miniaturization design of the electronic device 100.

In conclusion, according to the electronic device 100 provided in this embodiment of this application, the shielding effect of the electronic device 100 can be enhanced without increasing design space of the electronic device 100. This facilitates continuous evolution of electronic technologies.

The foregoing second shield layer 20 may be electrically connected to the circuit board 5 in a plurality of manners. That is, the second shield layer 20 may be grounded in a plurality of manners. The following uses some embodiments as examples to describe grounding manners of the second shield layer 20.

FIG. 6 to FIG. 11 are some diagrams of structures of the electronic device 100 according to an embodiment of this application. It may be understood that, to avoid forming an obstruction, the first shield layer 10 is not drawn in FIG. 6 to FIG. 11. This cannot be understood as that the first shield layer 10 does not exist.

In some embodiments, as shown in FIG. 6, at least a part of a side edge of the second shield layer 20 is in contact with the shield frame 40.

For example, with reference to FIG. 6, a side edge that is of the second shield layer 20 and that is closest to the shield frame 40 is in contact with the shield frame 40. For example, with reference to FIG. 5 and FIG. 6, a right side edge of the second shield layer 20 may be in contact with the shield frame 40.

"Contact" may be understood as that the second shield layer 20 abuts against the shield frame 40, or may be understood as that the side edge of the second shield layer 20 and the shield frame 40 are fastened, for example, may be soldered, or may be connected in another manner.

The second shield layer 20 is provided to be in direct contact with the shield frame 40, so that the second shield layer 20 can be electrically connected to the circuit board 5 through the shield frame 40. That is, the second shield layer 20 can be grounded by being in direct contact with the shield frame 40, and a grounding structure does not need to be separately designed, so that difficulty in manufacturing the electronic device 100 is reduced.

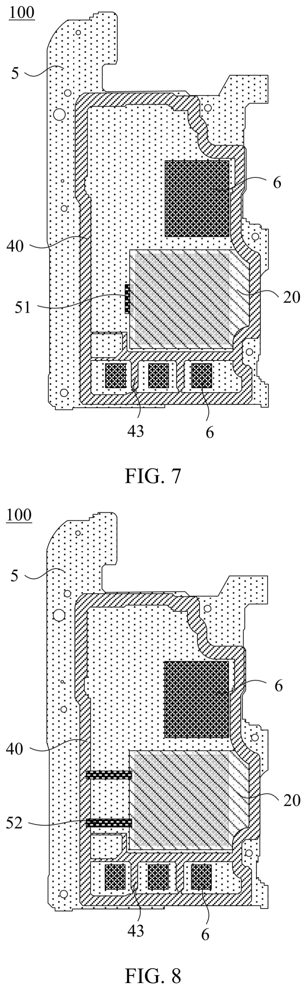

In some embodiments, as shown in FIG. 7, the electronic device 100 may further include a first connection part 51.

With reference to FIG. 7, one end of the first connection part 51 is electrically connected to the second shield layer 20, and the other end is electrically connected to the circuit board 5.

That is, the second shield layer 20 may be electrically connected to the circuit board 5 through the first connection part 51, to implement grounding.

For example, the first connection part 51 may be soldering tin or a conductive adhesive, or the first connection part 51 may alternatively be a metal folded tab that is integrally disposed with the second shield layer 20, or the first connection part 51 may alternatively be a conducting wire that electrically connects the second shield layer 20 to the circuit board 5. That is, the first connection part 51 may be any structure that can implement an electrical connection between the second shield layer 20 and the circuit board 5. A specific structure, a material, and the like of the first connection part 51 are not limited in embodiments of this application.

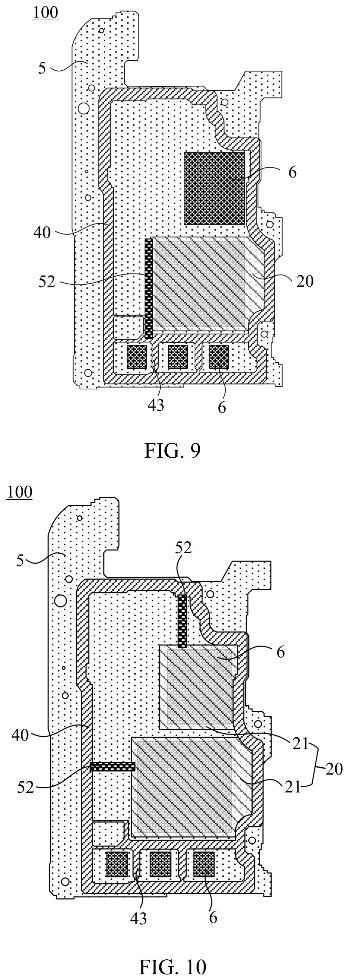

In some embodiments, as shown in FIG. 8 and FIG. 9, the electronic device 100 may further include a second connection part 52.

With reference to FIG. 8 and FIG. 9, one end of the second connection part 52 is electrically connected to the second shield layer 20, and the other end is electrically connected to the shield frame 40.

That is, the second shield layer 20 is connected to the shield frame 40 through the second connection part 52 and is electrically connected to the circuit board 5 through the shield frame 40. That is, after passing through the second connection part 52 and the shield frame 40 in sequence, the second shield layer 20 is connected to the circuit board 5 to implement grounding.

For example, for a structure or material setting of the second connection part 52, refer to the description of the first connection part 51 in the foregoing embodiment. Details are not described herein again.

For example, with reference to FIG. 8 and FIG. 9, a position and a design manner of the second connection part 52 may be changed (similar to those of the first connection part 51). For example, with reference to FIG. 8, the electronic device 100 may include two second connection parts 52, and the two second connection parts 52 may be disposed above and below a left side of the second shield layer 20. Alternatively, for example, with reference to FIG. 9, the second connection part 52 may be electrically connected to an entire side edge on the left side of the second shield layer 20.

For example, the position and the like of the second connection part 52 may be changed based on a frequency of electromagnetic interference generated by the electronic components 6 covered by the second shield layer 20, to control a size and a shape of the second shield cavity Q2 formed by the second shield layer 20, the second connection part 52, and the shield frame 40, so as to shield electromagnetic interference in a specific range (a position of the first connection part 51 is similar).

It may be understood that in this embodiment of this application, the positions and set shapes of the first connection part 51 and the second connection part 52 are not limited, and any setting manner of the first connection part 51 and the second connection part 52 that can enable the second shield layer 20 to be grounded falls within the protection scope of this embodiment of this application.

In some embodiments, an electrical connection manner between the second shield layer 20 and the circuit board 5 may include any one or a combination of the foregoing plurality of connection manners. For example, with reference to FIG. 6, the second shield layer 20 may only be in contact with the shield frame 40 on a right side to implement grounding. Alternatively, for example, with reference to FIG. 9, the left side of the second shield layer 20 may be electrically connected to the shield frame 40 through the second connection part 52, and the right side may be in direct contact with the shield frame 40.

In some embodiments, the second shield layer 20 includes at least one connection point, and the connection point is a part that is of the second shield layer 20 and that is connected to the circuit board 5. That is, the connection point is a grounding position of the second shield layer 20. For example, with reference to FIG. 5, the connection point is the right side edge of the second shield layer 20. For example, with reference to FIG. 6, the connection point includes the right side edge of the second shield layer 20 and a position that is on the left side edge and that is connected to the first connection part 51.

When the second shield layer 20 includes a plurality of connection points, the plurality of connection points are located on two sides, in the first direction, of the electronic components 6 covered by the second shield layer 20.

The first direction is any direction parallel to the circuit board 5.

For example, with reference to FIG. 9, the left side edge of the second shield layer 20 is connected to the shield frame 40 through the second connection part 52 and then grounded, and the right side edge is in contact with the shield frame 40 and then grounded. That is, the left side edge and the right side edge of the second shield layer 20 are separately used as connection points, and the two connection points are provided opposite to each other, so that the second shield cavity Q2 formed by the second shield layer 20 can cover an electronic component 6 corresponding to electromagnetic interference to be shielded.

In some embodiments, as shown in FIG. 10, each second shield layer 20 includes a plurality of first sublayers 21 that are spaced apart in the first direction, the first sublayers 21 are provided on one side that is of at least one electronic component 6 and that is away from the circuit board 5, and an orthographic projection of the first sublayers 21 on the circuit board 5 and an orthographic projection of the at least one electronic component 6 on the circuit board 5 at least partially overlap.

For example, the first sublayers 21 are suspended above a surface that is of the electronic component 6 and that is away from the circuit board 5, or are attached, in an insulated manner, to a surface that is of the electronic component 6 and that is away from the circuit board 5, to cover the at least one electronic component 6.

With reference to FIG. 10, each first sublayer 21 is coupled to the circuit board 5. For example, each first sublayer 21 and the circuit board 5 are electrically connected (directly coupled) or indirectly coupled, to implement grounding of the first sublayer 21.

The plurality of first sublayers 21 are provided, so that the second shield cavity Q2 may be further divided into a plurality of shield cavities with smaller volumes, to further improve a cut-off frequency and optimize the shielding effect of the electronic device 100.

For example, areas of different first sublayers 21 may be different, so that electromagnetic interference of different frequencies can be separately shielded, to avoid leakage of electromagnetic interference of some frequency bands.

For example, areas of the first sublayers 21 may be adjusted or grounding positions of the first sublayers 21 may be adjusted based on a frequency of electromagnetic interference generated by the electronic component 6 covered by the first sublayers 21.

For example, for a connection manner of the first sublayers 21 and the circuit board 5, refer to the description of a connection manner of the second shield layer 20 and the circuit board 5 in the foregoing embodiment. For example, the first sublayers 21 may also be in contact with the shield frame 40 to implement grounding or may implement grounding through the first connection part 51 and/or the second connection part 52. This is not described herein again.

For example, a spacing between two adjacent first sublayers 21 may be less than or equal to 1 cm.

In some embodiments, different first sublayers 21 may be grounded independently of each other. For example, with reference to FIG. 10, two first sublayers 21 may be separately connected to the shield frame 40 through different second connection parts 52 and then grounded, to form shield cavities independent of each other, so as to enhance the shielding effect on electromagnetic interference.

In some embodiments, as shown in FIG. 11, two first sublayers 21 that are adjacently provided may be electrically connected. For example, with reference to FIG. 11, the two adjacent first sublayers 21 may be electrically connected through a third connection part 53.

A resonance problem may occur between the two adjacent first sublayers 21. The resonance problem may be resolved by electrically connecting the two first sublayers 21 that are adjacently provided, and reliability of the electronic device 100 is improved.

For example, the foregoing resonance problem may further be resolved in another manner. For example, the spacing between the two adjacent first sublayers 21 may be increased, to reduce interference between the two first sublayers 21 and avoid generation of resonance. Alternatively, for example, ground points of the first sublayers 21 may be adjusted, so that frequencies of electromagnetic interference correspondingly shielded by different first sublayers 21 are matched, and the resonance problem can also be avoided.

For example, with reference to FIG. 11, after different first sublayers 21 are electrically connected, grounding may be implemented by using one of the first sublayers 21. That is, a grounding manner of the first sublayer 21 may be flexibly changed based on an application scenario. This is not limited in embodiments of this application.

FIG. 12 is another sectional view along a section line B-B' in FIG. 4.

In some embodiments, as shown in FIG. 12, when the electronic device 100 includes the plurality of second shield layers 20, two adjacent second shield layers 20 are electrically connected.

Alternatively, with reference to FIG. 5, the first shield layer 10 is electrically connected to a second shield layer 20 that is closest to the first shield layer 10.

For example, the plurality of second shield layers 20 are directly attached, and the second shield layer 20 and the first shield layer 10 are directly attached, to implement electrical connection. Alternatively, the electrical connection may be implemented in a connection manner such as a conductive adhesive, a conductive paste, punching and gluing, or punching and electroplating.

In this embodiment, while a shield cavity is added to enhance the shielding effect of the electronic device 100, a manufacturing process of the electronic device 100 may be simplified, and no process step of manufacturing an insulation layer needs to be added, so that difficulty in manufacturing the electronic device 100 is reduced.

In some other embodiments, when the electronic device 100 includes the plurality of second shield layers 20, at least two second shield layers 20 that are adjacently provided are spaced apart. For example, air is disposed between the at least two second shield layers 20, or an insulation material is disposed between the at least two second shield layers 20.

Alternatively, the first shield layer 10 and at least one second shield layer 20 (for example, the second shield layer 20 that is closest to the first shield layer 10) are spaced apart. For example, air is disposed between the first shield layer 10 and the at least one second shield layer 20, or an insulation material is disposed between the first shield layer 10 and the at least one second shield layer 20.

The first shield layer 10 and the second shield layer 20 are spaced apart, or the two adjacent second shield layers 20 are spaced apart, so that the first shield cavity Q1 and the second shield cavity Q2 are independent of each other, that is, the first shield cavity Q1 and the second shield cavity Q2 each implement a shielding function, to maximize utilization of respective shielding functions, so as to further improve an overall electromagnetic shielding effect of the electronic device 1000.

In some embodiments, as shown in FIG. 12, the electronic device 100 may further include a first insulation layer 61.

With reference to FIG. 12, the first insulation layer 61 may be provided between the second shield layer 20 and the first shield layer 10.

That is, the first shield layer 10 and the second shield layer 20 are insulated from each other and are spaced apart by using the first insulation layer 61, so that the first shield cavity Q1 and the second shield cavity Q2 are independent of each other, that is, the first shield cavity Q1 and the second shield cavity Q2 each implement the shielding function, to maximize utilization of the respective shielding functions, so as to further improve the overall electromagnetic shielding effect of the electronic device 100.

For example, when the first shield layer 10 and the second shield layer 20 are insulated from each other, after electromagnetic waves are conducted to the second shield layer 20, most electromagnetic waves are directly transmitted to a grounding position along the second shield layer 20 and dissipated. Because the first shield layer 10 and the second shield layer 20 are insulated from each other, it is more difficult to conduct the electromagnetic waves from the second shield layer 20 to the first shield layer 10, so that electromagnetic leakage is reduced, and an electromagnetic shielding effect is improved.

In some embodiments, as shown in FIG. 12, when the electronic device 100 includes the plurality of second shield layers 20, the electronic device 100 may further include a fourth insulation layer 64.

The fourth insulation layer 64 is provided between the at least two second shield layers 20 that are adjacently provided. Same as the description in the foregoing embodiment, the plurality of second shield cavities Q2 formed by the plurality of second shield layers 20 may also be independent of each other, so that a probability of electromagnetic wave leakage is reduced, and the overall electromagnetic shielding effect of the electronic device 100 is further improved.

For example, a thickness of the first insulation layer 61 and/or the fourth insulation layer 64 may be 1 µm to 100 µm.

For example, a material of the first insulation layer 61 and/or the fourth insulation layer 64 may include polyethylene terephthalate (polyethylene glycol terephthalate, PET for short) or polyimide (polyimide, PI for short).

For example, the material of the first insulation layer 61 and/or the fourth insulation layer 64 may be a high magnetic loss material (for example, a wave-absorbing material, for example, with a magnetic permeability greater than or equal to 1), a high dielectric loss material (for example, with a dielectric constant greater than or equal to 1), or a material with ultra-low electrical conductivity (for example, less than or equal to 1 S/m).

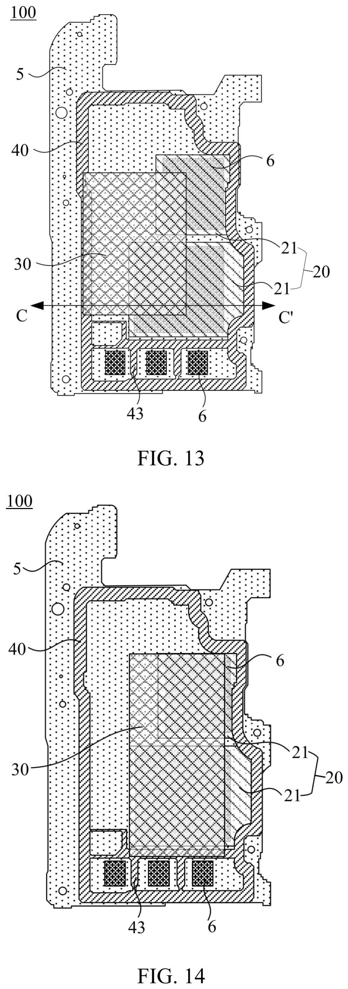

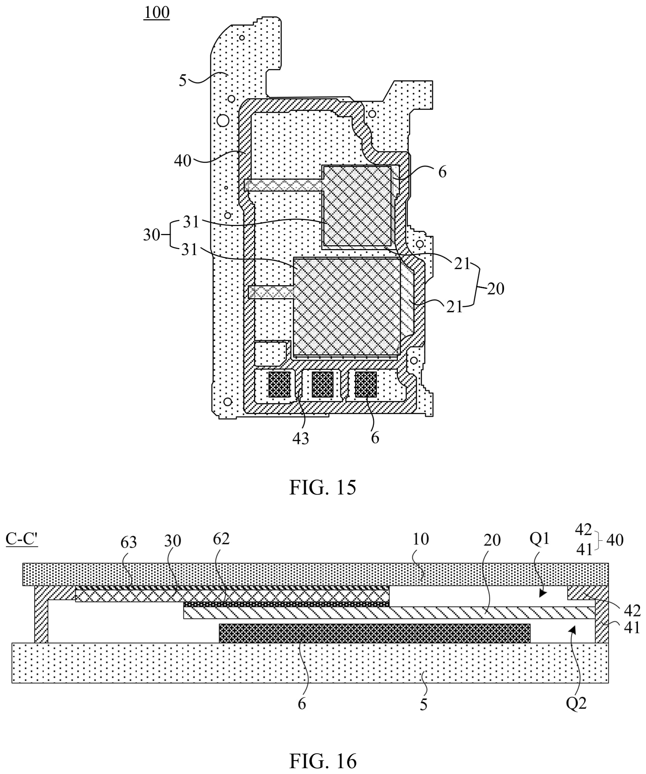

FIG. 13, FIG. 14, and FIG. 15 are diagrams of other structures after the electronic device 100 is disposed on the circuit board 5. FIG. 16 is a sectional view along a section line C-C' in FIG. 13.

It may be understood that, to avoid forming an obstruction, the first shield layer 10 is not drawn in FIG. 13, FIG. 14, and FIG. 15. This cannot be understood as that the first shield layer 10 does not exist. As shown in FIG. 16, the first shield layer 10 still exists on one side that is of the second shield layer 20 and that is away from the circuit board 5.

In some embodiments, as shown in FIG. 13 to FIG. 16, the electronic device 100 may further include a third shield layer 30 and a second insulation layer 62.

With reference to FIG. 16, the third shield layer 30 is provided on a side of the second shield layer 20.

For example, the third shield layer 30 may be provided on one side that is of the second shield layer 20 and that is close to the circuit board 5, or may be provided on one side that is of the second shield layer 20 and that is close to the first shield layer 10 (refer to FIG. 16), or may be provided on both one side that is of the second shield layer 20 and that is close to the circuit board 5 and one side that is of the second shield layer 20 and that is close to the first shield layer 10.

With reference to FIG. 13, FIG. 14, and FIG. 15, the third shield layer 30 and the second shield layer 20 at least partially overlap in a direction perpendicular to the circuit board 5. With reference to FIG. 16, the second insulation layer 62 is provided between the second shield layer 20 and the third shield layer 30.

That is, a capacitive structure may be formed among the third shield layer 30, the second insulation layer 62, and the second shield layer 20.

It should be noted that "at least partially overlap" herein means that there is an overlapping area (that is, an effective capacitive area) between the third shield layer 30 and the second shield layer 20. For example, on an orthographic projection of the circuit board 5, an orthographic projection of the third shield layer 30 and the orthographic projection of the second shield layer 20 at least partially overlap, to form a capacitive structure.

With reference to FIG. 16, the third shield layer 30 is electrically connected to the circuit board 5.

That is, the third shield layer 30 is configured to be electrically connected to the circuit board 5, and a capacitive structure is formed between the second shield layer 20 and the third shield layer 30, so that the second shield layer 20 implements capacitive coupling connection to the circuit board 5 through the third shield layer 30, that is, the second shield layer 20 may be coupled and grounded through the third shield layer 30.

For example, the third shield layer 30 may be electrically connected to the circuit board 5 directly (not shown in the figure, and reference may be made to the description of the first connection part 51 in the foregoing embodiment).

Alternatively, for example, the third shield layer 30 may also be connected to the shield frame 40, to implement an electrical connection to the circuit board 5 through the shield frame 40. For example, with reference to FIG. 13 and FIG. 14, the third shield layer 30 may be directly connected to the shield frame 40. Alternatively, with reference to FIG. 15, the third shield layer 30 may be electrically connected to the shield frame 40 through a connection part (similar to the second connection part 52 in the foregoing embodiment, and details are not described herein again). This is not limited in embodiments of this application.

For example, with reference to FIG. 13 and FIG. 14, a connection position between the third shield layer 30 and the shield frame 40 may be changed, to adjust an electromagnetic interference frequency range that can be shielded by the second shield layer 20.

For example, with reference to FIG. 13, the right side of the second shield layer 20 is in contact with the shield frame 40 to form a connection point (that is, a ground point), the left side of the second shield layer 20 is coupled to the third shield layer 30, and a left side of the third shield layer 30 is connected to the shield frame 40, so that another ground point of the second shield layer 20 can be extended to a left-side side frame of the shield frame 40. A spacing between two connection points (ground points) of the second shield layer 20 is large, so that the second shield cavity Q2 formed by the second shield layer 20 can shield electromagnetic interference of a high frequency.

Alternatively, for example, with reference to FIG. 14, the third shield layer 30 may alternatively be connected to a lower-side side frame of the shield frame 40 or may be connected to the middle bracket 43 of the shield frame 40, so that difficulty in electrically connecting the third shield layer 30 to the circuit board 5 can be reduced, or the electromagnetic interference frequency range that can be shielded by the second shield cavity Q2 formed by the second shield layer 20 can also be adjusted.

In the electronic device 100 provided in this embodiment of this application, the third shield layer 30 is provided, and the second shield layer 20 is provided to implement capacitive coupling connection (that is, coupling and grounding) to the circuit board 5 through the third shield layer 30. An area of the third shield layer 30 may be adjusted to adjust a capacitance of the capacitive structure formed by the second shield layer 20 and the third shield layer 30, so that a frequency selection effect can be formed, and shielding and suppression can be performed on electromagnetic interference of a specific frequency. In this way, the electronic device 100 can be flexibly used in different scenarios.

For example, with reference to FIG. 16, the third shield layer 30 may alternatively be provided in the first shield cavity Q1, to form the capacitive structure with the second shield layer 20 and avoid occupying too much design space of the circuit board 5.

For example, with reference to FIG. 16, when the third shield layer 30 is provided between the first shield layer 10 and the second shield layer 20, the third shield layer 30 is connected to the first shield layer 10.

For example, the third shield layer 30 and the first shield layer 10 may be directly attached, or the third shield layer 30 and the first shield layer 10 may be bonded by using a bonding adhesive. Alternatively, for example, with reference to FIG. 16, the electronic device 100 may further include a third insulation layer 63, and the third insulation layer 63 is provided between the first shield layer 10 and the third shield layer 30, to implement electrical insulation between the first shield layer 10 and the third shield layer 30.

In some embodiments, when the second shield layer 20 includes the plurality of first sublayers 21, as shown in FIG. 13 and FIG. 14, each first sublayer 21 and the third shield layer 30 at least partially overlap in the direction perpendicular to the circuit board 5.

That is, the plurality of first sublayers 21 may share one third shield layer 30, and the plurality of first sublayers 21 may form capacitive structures with a same third shield layer 30, so that the structure of the electronic device 100 can be simplified, and difficulty in manufacturing the electronic device 100 can be reduced.

Alternatively, as shown in FIG. 15, the third shield layer 30 may also include a plurality of second sublayers 31 that are spaced apart in the first direction (any direction parallel to the circuit board 5), and each first sublayer 21 and a corresponding second sublayer 31 at least partially overlap in the direction perpendicular to the circuit board 5.

That is, the plurality of first sublayers 21 may each correspond to a separate second sublayer 31, to form a plurality of capacitive structures that are independent of each other. This avoids mutual influence in a frequency selection process and further improves flexibility of frequency selection of the electronic device 100.

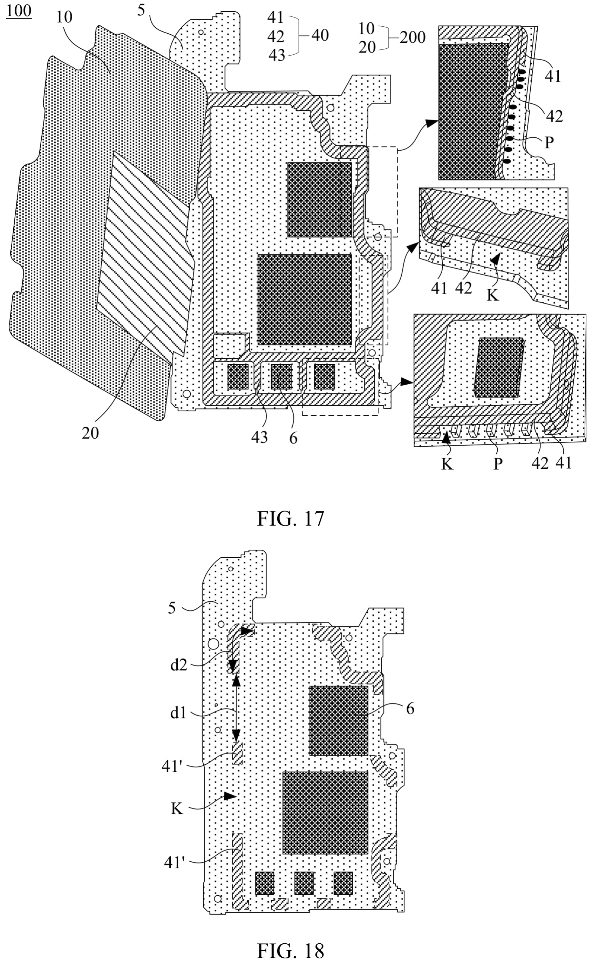

FIG. 17 is a diagram of a structure of the electronic device 100 and some corresponding partially enlarged diagrams according to an embodiment of this application. FIG. 18 is a diagram of an orthographic projection of the first bracket 41 of the shield frame 40 on the circuit board 5.

In some embodiments, the shield structure includes only the shield frame and the shield cover. To ensure the shielding effect, more than 90% of an area of a surface that is of the shield frame and that faces the circuit board 5 is connected (for example, soldered) to the circuit board, and large board surface design space of the circuit board is occupied. This is not conducive to implementing a miniaturization design of the electronic device 100.

In some embodiments provided in this application, as shown in FIG. 17, the shield frame 40 includes the first bracket 41.

With reference to FIG. 17, the first bracket 41 is disposed around the plurality of electronic components 6, a first side edge (a side edge close to the circuit board 5) of the first bracket 41 is connected to the surface of the circuit board 5, and a second side edge (a side edge away from the circuit board 5, that is, the first side edge and the second side edge are disposed opposite to each other) of the first bracket 41 is electrically connected to the first shield layer 10.

At least one first opening K that is spaced apart is disposed on the first bracket 41, the first opening K penetrates through the first bracket 41 in the direction parallel to the circuit board 5, and the first opening K cuts through the first side edge of the first bracket 41.

That is, not all the surface that is of the first bracket 41 and that faces the circuit board 5 is in contact with the circuit board 5, and a part of the surface is recessed in a direction away from the circuit board 5 to form the first opening K, so as to expose a part of the circuit board 5, so that board surface design space that is of the circuit board 5 and that is occupied by the shield frame 40 is reduced, and more components can be disposed on the circuit board 5. For example, with reference to FIG. 17, a pin P (or another electronic component that can meet an avoidance requirement) may be disposed at a position that is of the circuit board 5 and that corresponds to the first opening K, to facilitate implementation of a miniaturization design of the circuit board 5 and even the electronic device 100.

For example, a ratio of a total size of the at least one first opening K (for example, a plurality of first openings K) on an extension path of the first bracket 41 to a size of the first bracket 41 on the extension path is greater than or equal to 0.7 and less than 1.

For example, with reference to FIG. 18, the plurality of first openings K may divide the first bracket 41 into a plurality of parts 41', a size of each first opening K on the extension path of the first bracket 41 is a spacing d1 between two adjacent parts 41', and a sum of sizes of the plurality of first openings K on the extension path of the first bracket 41 is a sum of a plurality of spacings d1. A size of the first bracket 41 on the extension path is a sum of lengths d2 of the plurality of parts 41' in an extension direction of the plurality of parts 41'.

That is, the first opening K in the first bracket 41 is disposed and occupies 70% or more of an annular region enclosed by the first bracket 41. This greatly reduces design space that is of the circuit board 5 and that is occupied by the shield frame 40.

For example, a length d2 of each part 41' in the extension direction of the part 41' may be less than or equal to 20 mm.

In the electronic device 100 provided in this embodiment of this application, the second shield layer 20 is provided, so that most electromagnetic interference generated by the electronic components 6 can be grounded through the second shield layer 20 and dissipated. This greatly reduces electromagnetic interference transmitted to the first shield layer 10. Therefore, large space is reserved for providing the first opening K for the shield frame 40 connected to the first shield layer 10. Because most electromagnetic interference in the first shield cavity Q1 formed by the first shield layer 10 and the shield frame 40 is blocked by the second shield layer 20, even if the size of the first opening K of the shield frame 40 is increased, the shielding effect can also be enhanced, and both improvement of the shielding effect of the electronic device 100 and reduction of occupied design space are considered.

For example, as shown in FIG. 17, the shield frame 40 further includes the second bracket 42. The second bracket 42 is connected (for example, electrically connected) to the second side edge of the first bracket 41, and the first bracket 41 is connected to the first shield layer 10 through the second bracket 42.

For example, the first bracket 41 is perpendicular to the circuit board 5, and the second bracket 42 is parallel to the circuit board 5.

In some embodiments, a material of the first shield layer 10 and/or the second shield layer 20 may include a conductive material, for example, may be a metal material, for example, may include a metal material such as copper or silver, for example, may be a material such as nickel silver or stainless steel.

For example, material selection of the first shield layer 10 and the second shield layer 20 in the foregoing embodiment may comply with the following rules.

In some embodiments, electrical conductivity of the second shield layer 20 is greater than electrical conductivity of the first shield layer 10.

For example, when the electronic device 100 includes a plurality of second shield layers 20, electrical conductivity of the second shield layers 20 gradually decreases in the direction away from the circuit board 5.

For example, the electrical conductivity of the second shield layer 20 is greater than or equal to 5×10⁵ S/m; and/or the electrical conductivity of the first shield layer 10 is 0.06×10⁵ S/m to 5×10⁵ S/m.

For example, when thicknesses of the first shield layer 10 and the second shield layer 20 are less than or equal to 0.15 mm, the electrical conductivity of the second shield layer 20 is greater than or equal to 5×10⁵ S/m, and the electrical conductivity of the first shield layer 10 is 0.06×10⁵ S/m to 5×10⁵ S/m.

For example, the electrical conductivity of the second shield layer 20 may be 5×10⁵ S/m, 7.5×10⁵ S/m, or 11×10⁶ S/m. For example, the electrical conductivity of the first shield layer 10 may be 0.06×10⁵ S/m, 1.053×10⁵ S/m, 2.3×10⁵ S/m, 2.57×10⁵ S/m, 5×10⁵ S/m, or the like.

That is, a material of the first shield layer 10 located at an outer layer may be set as a high-loss material (that is, with low electrical conductivity), and a material of the second shield layer 20 at an inner layer may be set as a high-conductive material (that is, with high electrical conductivity). The first shield layer 10 having a high-loss characteristic can suppress generation of a resonance problem. In addition, when electromagnetic interference generated by the electronic components 6 reaches the second shield layer 20, the second shield layer 20 having a high-conductive effect may block most electromagnetic interference, and the remaining part of electromagnetic interference leaks to the first shield layer 10 and may be lost and dissipated in a process of transmission in the high-loss first shield layer 10. Under a joint effect of the high-loss first shield layer 10 and the high-conductive second shield layer 20, the shielding effect on electromagnetic interference in the electronic device 100 is greatly improved.

For example, when the material of the first shield layer 10 is the high-loss material, and the material of the second shield layer 20 is the high-conductive material, the size of the first opening K of the first bracket 41 in the shield frame 40 may be further increased, so that design space that is of the circuit board 5 and that is occupied by the shield frame 40 is further reduced.

For example, when the material of the first shield layer 10 is the high-loss material, and the material of the second shield layer 20 is the high-conductive material, the first shield layer 10 and the second shield layer 20 may be directly attached. When the electromagnetic waves are transmitted to the second shield layer 20, because the electrical conductivity of the second shield layer 20 is far greater than the electrical conductivity of the first shield layer 10, the electromagnetic waves are still transmitted along the second shield layer 20 with high electrical conductivity, are transmitted to the circuit board 5 through the grounding position of the second shield layer 20 and dissipated, and do not leak to the first shield layer 10.

In some embodiments, a thickness of the second shield layer 20 and/or a thickness of the third shield layer 30 may be less than or equal to 0.15 mm. For example, the thickness of the second shield layer 20 is 0.001 mm to 0.15 mm, and/or the thickness of the third shield layer 30 is 0.001 mm to 0.15 mm, for example, 0.001 mm, 0.015 mm, 0.08 mm, or 0.15 mm.

In some embodiments, a coefficient of thermal conductivity of the second shield layer 20 is greater than or equal to 50 W/(m×K), and/or a coefficient of thermal conductivity of the third shield layer 30 is greater than or equal to 50 W/(m×K). Therefore, while implementing a good electromagnetic shielding effect in the electronic device 100, the electronic device 100 can further have a good heat dissipation effect, thereby achieving a balance between the two.

In some embodiments, the material of the first shield layer 10 includes at least one of a carbon nanotube (carbon nanotube, CNT for short), graphene (graphene), carbon black (carbon black), and a two-dimensional transition metal carbide (nitride) (MXene). Therefore, the first shield layer 10 has a high dielectric loss and has a good heat dissipation effect, and a weight of the electronic device 100 can further be reduced.

In the electronic device 100 provided in the foregoing embodiment of this application, electromagnetic shielding efficiency may reach more than 60 dB, a design area that is of the circuit board 5 and that is occupied by the shield frame 40 may further be reduced by more than 70%, a temperature may be greatly reduced (for example, may be reduced to 52°C), and an overall weight of the electronic device 100 may be reduced by more than 50%, thereby achieving a significant beneficial effect.

As shown in FIG. 3, FIG. 5, and FIG. 17, an embodiment of this application further provides a shield structure 200. The shield structure 200 includes the first shield layer 10 and the at least one second shield layer 20.

The first shield layer 10 is configured to be connected to the shield frame 40 and enclose the first shield cavity Q1.

As shown in FIG. 3, FIG. 5, and FIG. 17, the at least one second shield layer 20 and the first shield layer 10 are stacked and connected. For example, the at least one second shield layer 20 and the first shield layer are directly attached and electrically connected, or are bonded by using a bonding adhesive, or are connected through an insulation layer, to implement fastening between the second shield layer 20 and the first shield layer 10.

As shown in FIG. 3, FIG. 5, and FIG. 17, the area of the second shield layer 20 is less than the area of the first shield layer 10. In this way, the second shield layer 20 can form the second shield cavity Q2 whose volume is less than that of the first shield cavity Q1, to improve the shielding effect on electromagnetic interference.

It should be noted that, for a specific provision manner of the first shield layer 10, the second shield layer 20, the shield frame 40, the first shield cavity Q1, and the second shield cavity Q2 in this embodiment, refer to any one of the foregoing embodiments, and details are not described herein again.

The foregoing descriptions are merely specific implementations of this application, but are not intended to limit the protection scope of this application. Any variation or replacement figured out by a person skilled in the art within the technical scope disclosed in the present disclosure shall fall within the protection scope of this application. Therefore, the protection scope of this application shall be subject to the protection scope of the claims.

## Claims

1. An electronic device, comprising:
a circuit board, wherein a plurality of electronic components are disposed on a surface of the circuit board;
a shield frame, connected to the surface of the circuit board;
a first shield layer, covering and connected to one side that is of the shield frame and that is away from the circuit board, wherein the circuit board, the first shield layer, and the shield frame enclose a first shield cavity, and the plurality of electronic components are located in the first shield cavity; and
at least one second shield layer, stacked with the first shield layer, wherein the at least one second shield layer is provided in the first shield cavity, the second shield layer is provided on one side that is of at least one electronic component and that is away from the circuit board, an orthographic projection of the second shield layer on the circuit board and an orthographic projection of the at least one electronic component on the circuit board at least partially overlap, and the second shield layer is coupled to the circuit board.

2. The electronic device according to claim 1, wherein the second shield layer comprises a plurality of first sublayers that are spaced apart in a first direction; the first direction is parallel to the circuit board; the first sublayers are provided on the side that is of the at least one electronic component and that is away from the circuit board; an orthographic projection of the first sublayers on the circuit board and the orthographic projection of the at least one electronic component on the circuit board at least partially overlap; and each first sublayer is coupled to the circuit board.

3. The electronic device according to claim 2, wherein at least two first sublayers that are adjacently provided are electrically connected.

4. The electronic device according to any one of claims 1 to 3, wherein at least a part of a side edge of the second shield layer is in contact with the shield frame.

5. The electronic device according to any one of claims 1 to 4, further comprising:
a first connection part, wherein one end is electrically connected to the second shield layer, and the other end is electrically connected to the circuit board.

6. The electronic device according to any one of claims 1 to 5, further comprising:
a second connection part, wherein one end is electrically connected to the second shield layer, and the other end is electrically connected to the shield frame.

7. The electronic device according to any one of claims 1 to 6, wherein the second shield layer comprises at least one connection point, and the connection point is a part that is of the second shield layer and that is connected to the circuit board; and
when the second shield layer comprises a plurality of connection points, the plurality of connection points are separately provided on two sides, in the first direction, of an electronic component covered by the second shield layer, and the first direction is parallel to the circuit board.

8. The electronic device according to any one of claims 1 to 7, wherein the first shield layer and the at least one second shield layer are spaced apart; and/or
when the electronic device comprises a plurality of second shield layers, at least two second shield layers that are adjacently provided are spaced apart.

9. The electronic device according to claim 8, further comprising:
a first insulation layer, wherein the first insulation layer is provided between the second shield layer and the first shield layer.

10. The electronic device according to claim 9, wherein when the electronic device comprises the plurality of second shield layers, the electronic device further comprises a fourth insulation layer, wherein the fourth insulation layer is provided between at least two second shield layers that are adjacently provided.

11. The electronic device according to any one of claims 1 to 10, further comprising:
a third shield layer, provided on a side of the second shield layer, wherein the third shield layer and the second shield layer at least partially overlap in a direction perpendicular to the circuit board, and the third shield layer is electrically connected to the circuit board; and
a second insulation layer, provided between the second shield layer and the third shield layer.

12. The electronic device according to claim 11, wherein when the second shield layer comprises the plurality of first sublayers:
each first sublayer and the third shield layer at least partially overlap in the direction perpendicular to the circuit board; or
the third shield layer comprises a plurality of second sublayers that are spaced apart in the first direction, the first sublayer and a corresponding second sublayer at least partially overlap in the direction perpendicular to the circuit board, and the first direction is parallel to the circuit board.

13. The electronic device according to any one of claims 1 to 12, wherein the shield frame comprises a first bracket, the first bracket is disposed around the plurality of electronic components, a first side edge of the first bracket is connected to the surface of the circuit board, and a second side edge of the first bracket is electrically connected to the first shield layer; and
at least one first opening is provided on the first bracket, the first opening penetrates through the first bracket in a direction parallel to the circuit board, and the first opening cuts through the first side edge of the first bracket.

14. The electronic device according to claim 13, wherein the shield frame further comprises a second bracket, the second bracket is connected to the second side edge of the first bracket, and the first bracket is connected to the first shield layer through the second bracket.

15. The electronic device according to claim 13 or 14, wherein a ratio of a total size of the at least one first opening on an extension path of the first bracket to a size of the first bracket on the extension path is greater than or equal to 0.7 and less than 1.

16. The electronic device according to any one of claims 1 to 15, wherein an area of the second shield layer is less than or equal to one half of an area of the first shield layer.

17. The electronic device according to any one of claims 1 to 16, wherein electrical conductivity of the second shield layer is greater than electrical conductivity of the first shield layer.

18. The electronic device according to any one of claims 1 to 17, wherein the electrical conductivity of the second shield layer is greater than or equal to 5×10⁵ S/m; and/or
the electrical conductivity of the first shield layer is 0.06×10⁵ S/m to 5×10⁵ S/m.

19. The electronic device according to any one of claims 1 to 18, wherein a thickness of the first shield layer is less than or equal to 0.15 mm, and or a thickness of the second shield layer is less than or equal to 0.15 mm.

20. The electronic device according to any one of claims 1 to 19, wherein a coefficient of thermal conductivity of the first shield layer is greater than or equal to 50 W/(m×K), and/or a coefficient of thermal conductivity of the second shield layer is greater than or equal to 50 W/(m×K).

21. The electronic device according to any one of claims 1 to 20, wherein a material of the first shield layer comprises at least one of a carbon nanotube, graphene, carbon black, and a two-dimensional transition metal carbide (nitride).

22. A shield structure, comprising:
a first shield layer; and
at least one second shield layer, stacked with and connected to the first shield layer, wherein an area of the second shield layer is less than an area of the first shield layer.

23. The shield structure according to claim 22, wherein the second shield layer comprises a plurality of first sublayers that are spaced apart in a first direction, the first direction is parallel to the first shield layer, and the first sublayers and the first shield layer are stacked and are connected.

24. The shield structure according to claim 23, wherein at least two first sublayers that are adjacently provided are electrically connected.

25. The shield structure according to any one of claims 22 to 24, wherein the area of the second shield layer is less than or equal to one half of the area of the first shield layer.

26. The shield structure according to any one of claims 22 to 25, wherein electrical conductivity of the second shield layer is greater than electrical conductivity of the first shield layer.

27. The shield structure according to any one of claims 22 to 26, wherein the electrical conductivity of the second shield layer is greater than or equal to 5×10⁵ S/m; and/or
the electrical conductivity of the first shield layer is 0.06×10⁵ S/m to 5×10⁵ S/m.

28. The shield structure according to any one of claims 22 to 27, wherein a thickness of the first shield layer is less than or equal to 0.15 mm, and/or a thickness of the second shield layer is less than or equal to 0.15 mm.

29. The shield structure according to any one of claims 22 to 28, wherein a coefficient of thermal conductivity of the first shield layer is greater than or equal to 50 W/(m×K), and/or a coefficient of thermal conductivity of the second shield layer is greater than or equal to 50 W/(m×K).

30. The shield structure according to any one of claims 22 to 29, wherein a material of the first shield layer comprises at least one of a carbon nanotube, graphene, carbon black, and a two-dimensional transition metal carbide (nitride).
